# EUROPEAN PATENT SPECIFICATION

(11) **EP 4 018 485 B1**
(45) Date of publication and mention of the grant of the patent: **01.07.2026**
(21) Application number: 20747441.2
(22) Date of filing: 05.08.2020
(51) Int. Cl.: H10F 19/85, H10F 77/42

(54) **PHOTOVOLTAIC MODULE**
FOTOVOLTAISCHES MODUL
MODULE PHOTOVOLTAÏQUE

(30) Priority: 20.08.2019 EP 19192564
(43) Date of publication of application: 29.06.2022
(73) Proprietor: BASF Coatings GmbH, 48165 Münster (DE)
(72) Inventor: KRABBENBORG, Sven, Olle, 48165 Muenster (DE); KUES, Jan-Bernd, 48165 Muenster (DE); MUNDUS, Markus, 48165 Muenster (DE); SCHMIDT, Vjosa, 48165 Muenster (DE); BUJARD, Patrice, 1304 Cossonay-Ville (CH)
(74) Representative: Coatings IP Association
(86) International application number: PCT/EP2020/072033
(87) International publication number: WO 2021/032489

(56) References cited:
- EP-A1- 3 214 659
- CN-U- 206 834 186
- US-A1- 2013 087 200
- US-A1- 2014 326 306
- US-A1- 2016 079 462

## Description

Present invention relates to a photovoltaic module comprising photovoltaic (PV) cells capable of converting light incoming from the front side and from the rear side and a structured reflector of a transparent material on its back side, which allows rear light entry and reflection of unused light from the module's front side towards the cells, and further to a method for improving efficiency of a bifacial module by structuring its back side, as well as the use of a structured layer of transparent material for improving the efficiency of a bifacial photovoltaic module.

Typical photovoltaic modules, also known as solar modules, comprise an array of photovoltaic (PV) cells, generally formed from 2 or more "strings" of PV cells, with each string consisting of a plurality of PV cells arranged in a row and electrically connected in series. The PV cells are typically arranged on a transparent polymer layer or encapsulated in such a layer. Two panels of glass or other suitable polymeric material usually are positioned adjacent and bonded to the front side and backside of the encapsulant. At least the front panel is transparent to solar radiation, the backside panel may be transparent, or may be formed as an opaque layer e.g. containing a metal layer; the two panels are also referred to as front side layer or front cover member, and backside layer or back sheet (also recalled as back plate), respectively. The encapsulant is a light-transparent polymer arranged around the PV cells (in optical contact with the cell, such that it encapsulates the PV cells) and is also bonded to the front side layer and back sheet so as to physically seal off the cells. This laminated construction provides mechanical support for the cells and also protects them against damage due to environmental factors such as wind, snow and ice.

In principle, modules containing photovoltaic cells able to convert light incoming from the front side and from the rear side (i.e. bifacial PV cells) also permit the usage of light reaching the cell from the "wrong" side (i.e. from the rear), and thus may provide a potential for increased efficiency.

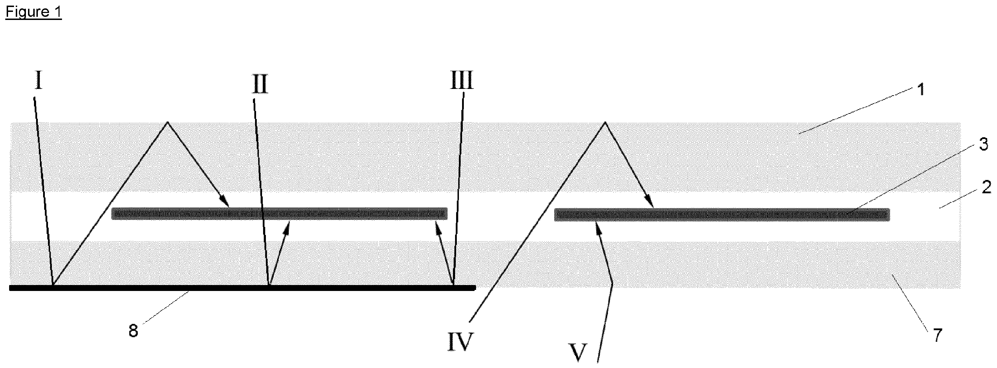

The basic module construction still loses a certain fraction of light reaching the module. Figure 1 gives a schematic representation of some possible light paths in 2 typical classes of bifacial modules depicted on the left side and on the right side of the figure, showing the cross section of the modules with front plate (1, typically glass), PV cells (3), encapsulant (2, e.g. EVA), back plate (7, e.g. another glass plate). The left side of the figure further shows, as additional element, a reflecting layer (8) on the back plate or integrated into the back plate, which layer may cover the space between cells (cell gap) and optionally below the cells, and may be arranged on the back plate (7) or between the elements (2) and (7).

In case that the module is equipped with a reflecting back layer (8, shown on the left side of Figure 1), light entering from the front side and missing the cell becomes reflected and may reach the cell directly (light path III) or after reflection on the front interface (light path I), and light passing the cell without getting absorbed, which occurs more likely for near IR light, is reflected towards the cell again (light path II).

Where the back plate is not equipped with the reflecting layer (8; right side of Figure 1), light following paths I - III gets lost to large extent, while light reaching the module from the back side may reach the cells (light paths IV and V). A module of this type has been proposed in EP3214659A, whose transparent back plate is covered with a surface texture comprising a plurality of square based pyramids to enhance efficiency. A further loss of light is caused by reflections on the back side of the PV cell: While the cell's front sides commonly carry an anti-reflection structure (PV cells carrying such structure are also known as "black silicon"), such anti-reflection properties typically are missing on the cell's back side, thus leading to losses by reflection especially for light path V.

It has now been found that disadvantages in both constructions shown in Figure 1 may be avoided, and an improved efficiency of the bifacial module may be obtained, if a structured layer is applied to the module's back side, which is transparent and thus not only allows for rear light entry, but also reflects unused light from the front side back towards the cells. This effect may be obtained by a structuring of the back sheet's surface, which provides internal reflection of light coming from the front side, and also provides transparency and light entry from the back side of the module.

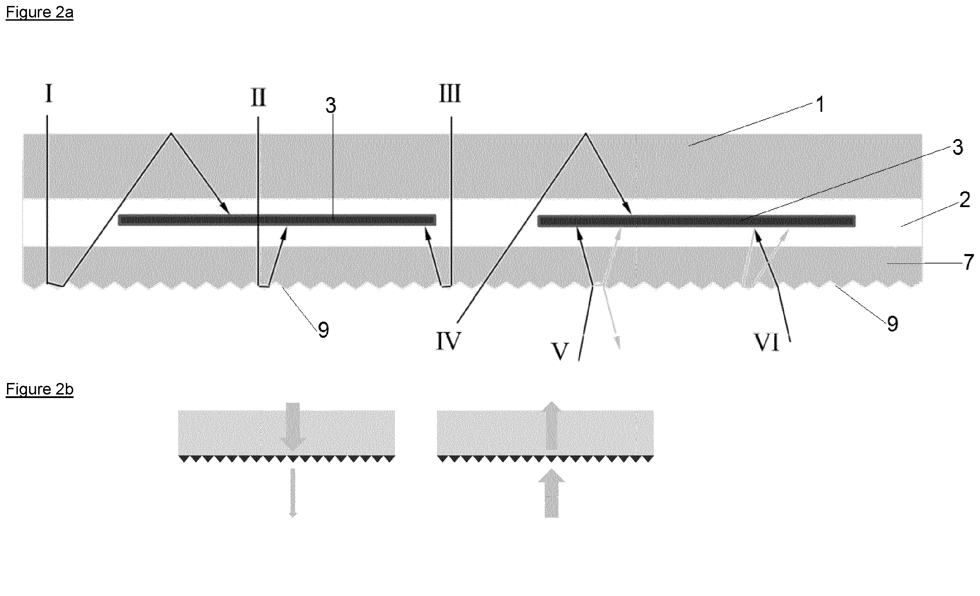

Figure 2a gives a schematic representation of typical light paths in such a bifacial module of the invention (cross section) comprising front plate (1, typically glass), PV cells (3), encapsulant (2, e.g. EVA), back plate (7, e.g. another glass plate or polymer sheet such as a PET sheet) showing the cross section of a structured layer (9) on the outer surface of the back plate (7). Light entering from the front side and missing the cell becomes reflected by the structuring of the additional layer (9) to a large extent and may reach the cell directly (light path III) or after reflection on the front interface (light path I), and light passing the cell without getting absorbed gets reflected towards the cell again (light path II), while light reaching the module from the back side may reach the cells (light paths IV and V), and light reflected from the cell's back side may get further reflected towards the cell (light path VI).

It has been found that a structuring of said layer (9) with a plurality of triangular based pyramids provides an especially efficient light usage and thus may be described as an anisotropic reflector, which provides higher reflectivity for light coming from the module's front side than for light reaching the module's back side (as schematically shown in Figure 2b).

The invention thus primarily pertains to a photovoltaic module comprising one or more bifacial photovoltaic cells (3), which module comprises a front side exposing an upper external surface designed for receiving direct sunlight and a rear side exposing a lower external surface designed for receiving diffuse light, wherein the lower external surface is formed, at least in part, by a microstructured layer (9),
characterized in that said microstructured layer (9) comprises pyramidal microstructures whose triangular bases are fixed in said layer (9).

More specifically, present invention pertains to a photovoltaic module comprising a front plate (1) optionally covered by an antireflex layer, the front plate (1) covering the photovoltaic cells (3), which cells are embedded in an encapsulant (2), and an optional back sheet (7) and/or interlayer (10),
wherein front plate (1), encapsulant (2), photovoltaic cells (3), and optional antireflex layer, back sheet (7) and interlayer (10), stand in optical contact with each other;
and front plate (1), encapsulant (2), and optional antireflex layer and back sheet (7) and interlayer (10), each are made of a transparent material,
wherein the encapsulant (2) or back sheet (7) or interlayer (10) thus forms an essentially plane rear surface, which is, at least in part, covered by the microstructured layer (9) comprising a plurality of triangular based pyramids.

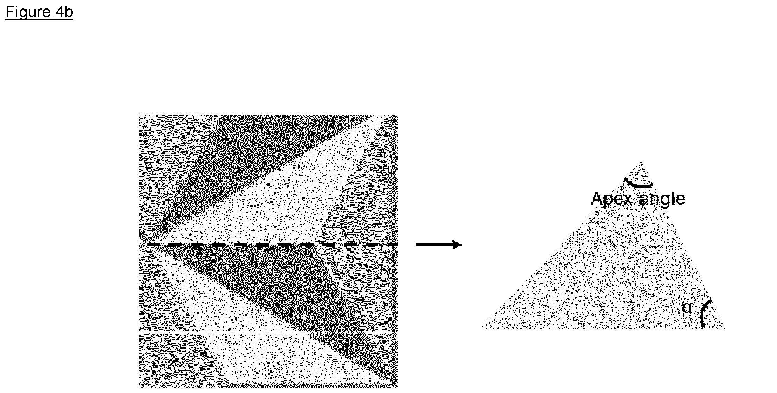

The structured layer (9) requires transparent planes, which are inclined against the back sheet by an angle alpha (see Fig. 4b) typically from the range 15 to 89°, see further below. The module's back sheet (7), typically forming a flat transparent surface, may comprise one or more layers; it forms the substrate on which the structured layer (9) is applied, or the back sheet itself may be structured in the described manner to obtain the structured surface (9) or surface layer (9). Layer (9) makes up the module's lower surface (i.e. the interface between transparent materials of refractive index typically from 1.4 to 1.7, see below) and air, thus providing total internal reflection for a plurality of light incident from the front side. As a result of the present structured layer on the module's back side, transmission of perpendicularly incoming light from the front side and falling on the gap between cells is strongly reduced (typically 0-60% of incoming light, as shown on the left side of Figure 2b), while present structures allow nearly unhindered transmission of light perpendicularly falling on the module's back side (typically more than 80%, especially 80-100% of incoming light, as shown on the right side of Figure 2b). In total, the light yield of the present module is distinctly improved, as shown further below.

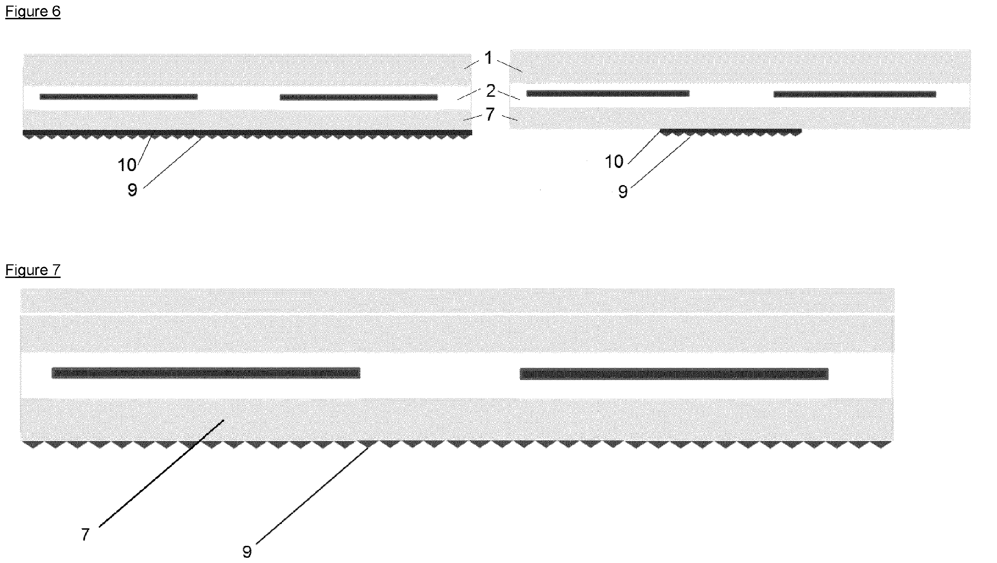

The present microstructures are at least arranged below the gaps between cells (3), or preferably across the whole back sheet (7), as exemplified in Figure 6.

Consequently, the photovoltaic module according to the invention generally does not contain a metal or diffuse reflector (i.e. reflector of a non-transparent material).

Since the present modules are especially efficient using light falling on the modules back side, they are preferably mounted over surfaces having a reflectivity (albedo) of 5% or more, especially of 20% or more; examples for such surfaces are roof tiles, concrete, sand. The module may be oriented parallel or tilted with respect to the reflecting surface.

Hereafter, the term "film" is synonymous with a sheet and like structures.

The expression "structured reflector sheet" or "microstructured reflector sheet" is synonymous with reflector sheet, structured reflector film, light reflecting film, structured layer, structured back sheet.

The term "upper" and "front" denotes the side directed towards the incident sunlight and the term "low", "lower", "below" and "back" denotes the opposite side.

The term "back sheet" or "back plate", as used for the PV module according to the invention, denotes the transparent lower cover of the photovoltaic module comprising a surface, on which the present structured layer is applied (thus also recalled as "substrate sheet"). The substrate sheet may consist of one layer (e.g. a glass sheet) or 2 or more layers (e.g. glass sheet or polymer sheet plus one or more polymer layers; an example for a back sheet comprises an EVA primer, a PET core consisting of 1 or more layers, followed by a UV coating as a protection layer).

The term "back plane" denotes the lower surface of the back sheet, which is typically flat and parallel to the PV cells, and on which the present structured layer is applied. The terms "solar cell" or "PV cell" denotes any photovoltaic cell, such as monocrystalline cells, multicrystalline cells, ribbon silicon cells, thin film cells, etc.; cells contained in the present PV module are capable of converting light incoming from the front side and from the rear side, as typically realized by bifacial cells.

The term "transparent" denotes a transmission of visual light essentially without scattering, typically effecting solar light transmission of more than 90% with scattering less than 10%. A transparent material thus generally denotes a material of optical quality. A microstructure comprising inclined planes and consisting of transparent material thus provides transmission through said material, while effecting light diffraction on each of its microplanes generally in accordance with geometrical optics.

The term "encapsulant" denotes a transparent polymer material enclosing ("embedding") the PV cells from all sides; a typical encapsulant material is EVA.

The term "Angstrom" denotes a length of 10⁻¹⁰ meter.

The term "solar module" is synonymous with a photovoltaic module or PV module. The assembly forming the present solar module generally is mounted in a way to distinguish between front side and back side.

Wherever mentioned, the refractive index of a material is as determined for a radiation of 589 nm (sodium D line), if not indicated otherwise.

The solar module according to the invention comprises a plurality of electrically interconnected bifacial solar cells having a front side receiving the directly incident light. The solar cells are arranged in a pattern where at least two cells are spaced from each other by areas with no solar cells, and the structured layer at least overlaps with the areas free of solar cells.

The principle of the invention is independent of the current conventional column/row arrangement of solar cells in solar modules. According to one embodiment, the solar cells are arranged in rows and columns, where at least one of the rows or columns are being spaced from each other.

The present structured layer (9), together with its optional carrier film (10) is in direct optical contact with the back sheet (7) and/or the encapsulant (i.e. the polymer layer or lowest polymer layer below the cells).

The photovoltaic module according to the invention generally contains a front plate (1), which is advantageously covered by an antireflex layer; the front plate (1) covers a bifacial photovoltaic cells (3), which are embedded in a transparent polymer material (2), whose other side (i.e. back side, opposite to incoming light) is covered by a transparent back sheet (7) whose surface is, at least in part, covered by the transparent structured layer (9) which forms at least a part of the module's lower surface. Cells such as common silicon-based PV cells are typically separated by a gap, e.g. of 1 to 10 mm width; the structured layer (9) then covers the back plane at least below these gaps.

In another embodiment of the invention, PV cells (3) incorporated in the module, which do not require such gaps, as it is typically the case for thin film modules, often based on organic PV cells. In modules of the invention comprising such gapless PV cells, the structured layer (9) preferably covers the whole back plane.

In one embodiment of the invention, the structured layer (9) covers a polymer film (10) standing in optical contact with the module's back sheet (7), or the structured layer (9) covers a polymer film (7) in optical contact with the encapsulant (2), each optionally by applying an adhesive interlayer.

In a further embodiment, the structured layer (9) directly covers the module's back sheet (7), which back sheet (7) is a polymer sheet or glass sheet; typically in these embodiments, the structured layer may be a structured radiation cured coating (9) e.g. on glass sheet or polymer sheet (7), or an embossed layer on the polymer sheet (7) or the embossed surface of polymer sheet (7).

### Structures

The microstructured layer (9) of present photovoltaic module comprises pyramidal microstructures with triangular bases and apexes pointing away from the module's front side. Typically, the microstructured layer (9) comprises pyramids, whose lateral faces each are inclined against the back plane by an angle (alpha) from the range 15 to 89°, preferably 15 to 75°, more preferably 25 to 70°, most preferably 25 to 65°, especially 35 to 65°; the back plane is defined by the essentially plane rear surface.

The pyramidal microstructures fill at least 90%, especially at least 95%, of the surface of the microstructured layer (9). The length of the pyramid's triangular bases are from the range 1 to 600 micrometer, preferably from the range 5 to 400, more preferably 12 to 200, especially 20 to 100 micrometer. The pyramid's apex angle is from the range 30° to 135°, especially 60 to 120°.

The structured surface (9) thus contains inclined planes of the pyramids lateral faces, whose longest side length (L) and shortest side lengths typically are from the range 1 to 600 micrometer, e.g. from the range 1 to 100 micrometer or 10 to 300 micrometer.

In one embodiment, the module's back side surface comprises more than 90%, especially more than 95%, of said inclined planes, based on the total surface. The height (h) of a pyramid is the line from its apex that makes equal angle with its three faces. For perfect pyramids (such as perfect cube corners with 90° between the cube faces), this line is perpendicular to the sheet substrate surface (i.e. the back plane). The height may deviate up to 25° from the normal to the sheet surface; the preferred deviation angle (also known as cant angle) is 10° and more preferred 5° or less.

The transparent microstructures form pyramids, whose triangular bases stand on the back plane; their heights typically stand perpendicularly to the back plane or deviate up to 25° from the back plane normal.

Consequently, the apex angles of such pyramids are from the range 30 to 150° (preferably 50 to 120°), and pyramids have a typical height from the range 10 to 300 micrometer.

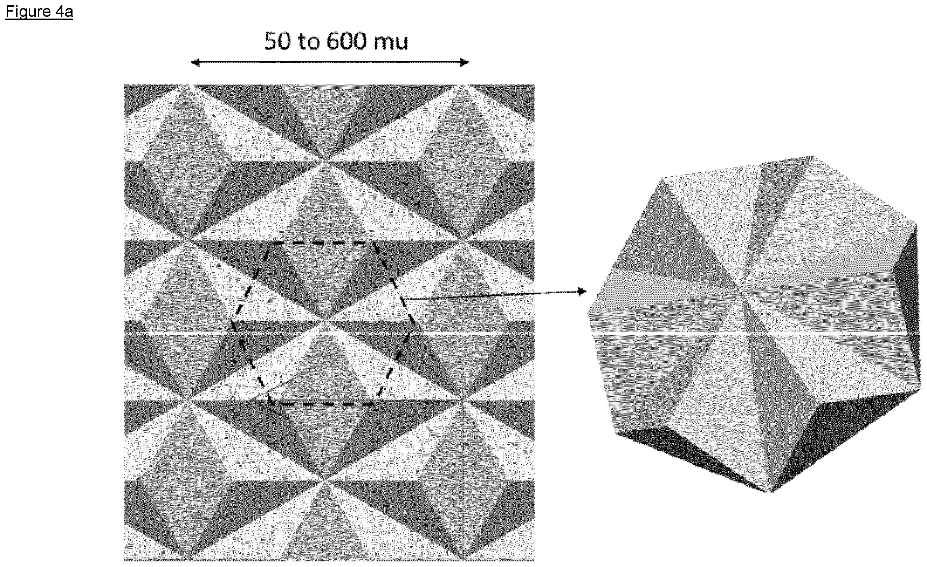

Figure 4a shows an example for a "cube-corner" structuring with pyramids of triangular base. Preferred are structures which may be prepared by crossed gratings (e.g. as shown in Figure 4a and further explained below). More preferred are structures consisting of such pyramids of triangular base, an example of which is shown in Figure 4a ("mu" standing for micrometer; the structure can be described as "cube corners" of typical apex angle about 90°).

### Materials and Methods

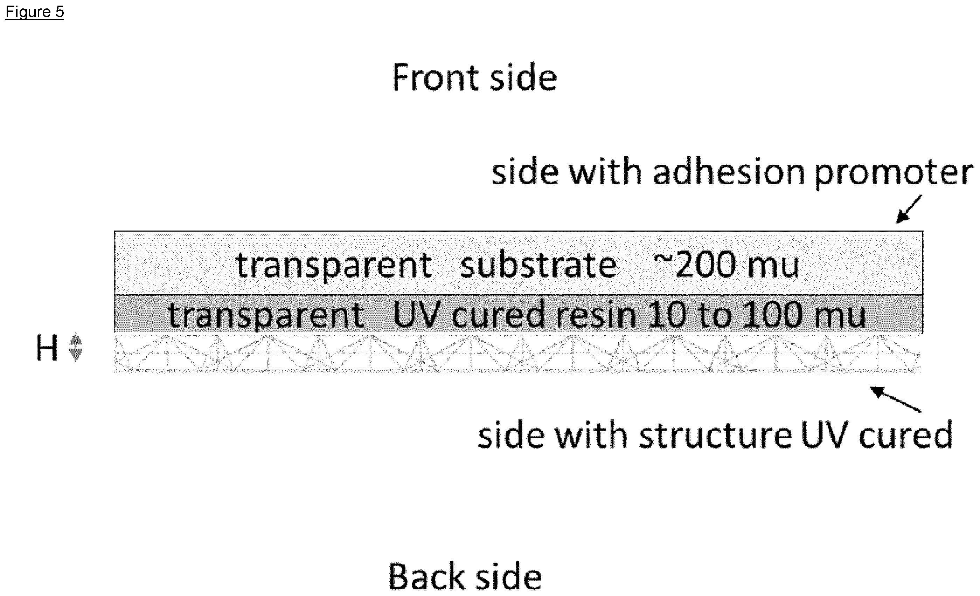

The structured layer (9) is generally prepared from a resin material which is transparent and curable by application of heat and/or radiation, or by suitable embossing of a transparent polymer material. The structured layer (9) may be applied directly onto the back sheet (7), or embossed into it in case that a polymeric back sheet is used, or the structured layer (9) may be applied on, or embossed into, a polymer film (10) as a transparent substrate, which polymer film carrying the structured layer (9) is then applied to the back sheet (7), preferably using a suitable adhesive between back sheet (7) and carrier film (10); examples are shown in Figures 5 and 6.

In one embodiment, the photovoltaic module according to the invention thus contains the transparent structured layer (9) comprising a resin cured by actinic radiation, especially UV radiation. The latter embodiment is of specific technical interest, especially where a UV curable resin layer is applied to a polymer film such as a PET film, structured by an imprinting process and cured by UV light, thereby forming the structured layer (9) on said polymer film. The so obtained laminate is subsequently applied to the back sheet (7).

The most preferred configuration of the present module comprises:
- Back sheet consisting of a structured UV coating on the PET core; or
- glass back sheet covered by structured UV-coating (without PET substrate), optionally with an adhesive on the glass plate.

Other preferred configurations comprise a structured UV-coating on PET, applied with an adhesive on the (glass or polymer) backsheet.

One process may be an imprinting process and, preferably, a roll-to-roll imprinting process. In a preferred embodiment, the laminate carrying the structured layer (9) is prepared as a single construction by an UV imprinting process. In another embodiment, the coated substrate is prepared from a radiation curable (meth)acrylate material, and the molded (meth)acrylate material is cured by exposure to actinic radiation. For example, a curable polymeric material may be coated on a substrate film (10 or 7) and pressed against a microstructured molding tool and allowed to cure e.g. by UV irradiation to form the structured layer (9) on the substrate film. Upon removal of the molding tool, the structured layer (9) is formed. The structure on the imprinted surface (9) is the inverse of structure on the tool surface, that is to say a protrusion on the tool surface will form a depression on the imprinted surface, and a depression on the tool surface will form a protrusion on the imprinted surface.

Optionally, the resulting product comprising carrier film (10) and structured layer (9) may be cut into strips of appropriate size and applied to the back sheet (7) to overlap with the area free of solar cells. Preferably, the strip has at least the same size and shape as the area between the solar cells.

For such an assembly, a better adhesion on the back sheet (7), which usually comprises glass or polymer film, or on the encapsulant (2), may be achieved by putting an adhesion promoter on the surface of the substrate side without structure (Figure 5).

In another embodiment, layer (9) is applied directly on the back sheet (7), which may be glass or a polymer material described further below, over the full surface or sequentially in analogy to Figure 6; Figure 7 shows such an assembly with layer (9) covering the largest part of the back sheet.

In another embodiment in accordance with Figure (7), layer (9) replaces the outer layer of the back sheet (7) or is part of the back sheet (7), especially where a polymer film or sheet, or the encapsulation material (2) itself such as EVA, also forms the back sheet (7).

In case that a resin material curable by heat and/or radiation is used for preparing the structured layer (9), a UV curable resin is preferred. In this case, the binder essentially comprises monomeric or oligomeric compounds containing ethylenically unsaturated bonds, which after application are cured by actinic radiation, i.e. converted into a crosslinked, high molecular weight form. Where the system is UV-curing, it generally contains a photoinitiator as well. Corresponding systems are described in the abovemen-tioned publication Ullmann's Encyclopedia of Industrial Chemistry, 5th Edition,

Vol. A18, pages 451-453. The resin composition typically further contains one or more stabilizers, e.g. a sterically hindered amine and a UV absorber.

Dual cure systems, which are cured first by heat and subsequently by UV irradiation, or vice versa, comprise components contain ethylenic double bonds capable to react on irradiation with UV light, typically in presence of a photoinitiator.

The electromagnetic radiation thus preferably is UV light, and the radiation curable coating typically is a UV curable coating. Cure of the UV curable coating (UV lacquer) during the transfer step may be accomplished in analogy to methods described in WO 12/176126. Preferred curing wavelengths are, for example, from the short wavelength range 220 - 300 nm, especially 240 - 270 nm, and/or from the long wavelength range 340 - 400 nm, especially 350 - 380 nm, as achievable e.g. by LED curing.

The structured layer (9) may alternatively be prepared by embossing. In this process, a flat film with an embossable surface is contacted to a structured tool with the application of pressure and/or heat to form an embossed surface. The entire flat film may comprise an embossable material, or the flat film may only have an embossable surface. The embossable surface may comprise a layer of a material that is different from the material of the flat film, which is to say that the flat film may have a coating of embossable material at its surface. The structure on the embossed surface is the inverse of structure on the tool surface, that is to say a protrusion on the tool surface will form a depression on the embossed surface, and a depression on the tool surface will form a protrusion on the embossed surface.

A broad range of methods are known to those skilled in this art for generating microstructured molding tools. Examples of these methods include but are not limited to photolithography, etching, discharge machining, ion milling, micromachining, diamond milling, diamond drilling, and electroforming. Microstructured molding tools can also be prepared by replicating various microstructured surfaces, including irregular shapes and patterns, with a moldable material such as those selected from the group consisting of crosslinkable liquid silicone rubber, radiation curable urethanes, etc. or replicating various microstructures by electroforming to generate a negative or positive replica intermediate or final embossing tool mold. Also, microstructured molds having random and irregular shapes and patterns can be generated by chemical etching, sandblasting, shot peening or sinking discrete structured particles in a moldable material. Additionally, any of the microstructured molding tools can be altered or modified according to the procedure taught in US Patent 5,122,902 (Benson). The tools may be prepared from a wide range of materials including metals such as nickel, copper, steel, or metal alloys, or polymeric materials.

The substrate (7) may comprise one or more layers and can be made of transparent materials such glass and/or polymers, like polyethylene terephthalate (PET), polymethylmethacrylate (PMMA), polyethylene (PE), polystyrene (PS), polypropylene (PP), polycarbonate (PC) or cyclic olefin (co)polymers (COC/COP) or other common thermoplastics combined or not with thermoset polymers like for example polyimide (PI), cellulose triacetate (TAC). The index of refraction of these transparent materials often is from the range 1.4 to 1.7, typically from the range 1.4 to 1.6. In special case of birefringence (especially PET) the index of refraction along the plane of the substrate may be higher than 1.6.

Any polymer layer used as back sheet (7) or encapsulant (2) embedding the PV cells is a transparent polymer material, which is often selected from polycarbonate, polyester (e.g. PET), vinyl polymers such as polyvinyl alcohol or ethylene vinyl acetate (EVA), including acrylics like polymethylmethacrylate, and the like. Examples for encapsulants (2) are polycarbonate, poly-acrylics such as PMMA, polyvinylbutyral, silicone polymers, polyimide, polystyrene, sty-rene acrylonitrile, polyamide, polyetherimide, polysulfone, cyclic olefin copolymer, and especially EVA. Optical quality of some polymers such as PE or PP can be improved by addition of clarifyers. It may consist of one bulk material (encapsulant) in contact with the structured layer of the invention and back sheet and the PV cells, or it may comprise two or more layers of such material. The thickness of the polymer layer(s) (7), arranged adjacent to the cells and opposite to the side of main incidence of light between structured layer (9) and the PV cells (3), if present, typically reaches up to 2 mm, and often ranges e.g. from 1 micrometer to about 2 mm, preferably its thickness is about 0.1 to 1 mm, especially 0.3 to 0.5 mm. The polymer film (10) may be of the same or a different material as the polymer back sheet (7); it may, alternatively, replace the polymer back sheet (7). A typical material for the polymer film (10) is polyethylene terephthalate (PET). A polymer film (10) may be one-layered or multi-layered. Likewise, polymeric substrate sheets (7) may be one-layered or multi-layered, or a polymer-glass sheet (7) of 2 or more layers may be employed.

Typically, the front plate (1) carries an antireflective element, which may form the textured surface of the front plate or it may be an antireflective coating applied to said front plate. Coatings typically are transparent or translucent porous materials with index-matching properties, e.g. comprising suitable dielectric particles such as silicon dioxide or alumina in a suitable binder, such as materials disclosed by Wicht et al. (Macromolecular Materials and Engineering 295, 628 (2010)). Coatings may be made of low refractive index materials such as MgF2 or fluoropolymers. The antireflective element may also consist of a multi-layer interference system having alternating layers of a low refractive index material and a high refractive index material. The antireflective element may also be a film with a nanostructured surface, e.g. a film with a moth's eye structure (a structure consisting of a hexagonal pattern of bumps).

A further aspect of the invention is the method of preparing the solar modules.

The invention thus further pertains to a method for the manufacturing of a photovoltaic module comprising PV cells capable of converting light incoming from the front side and from the rear side, which method comprises the step of structuring the module's transparent back side with microstructures in a layer of a transparent coating material either by applying, structuring and curing said coating material on the module's back side, or by applying a transparent sheet onto the module's back side wherein said sheet contains one microstructured surface comprising an UV cured coating material, characterized in that said microstructures comprise a plurality of triangular based pyramides.

In one embodiment, the method of the invention comprises the steps
(a) applying a transparent radiation curable resin layer to a polymer film such as a PET film,
(b) structuring said radiation curable resin layer by imprinting with a suitably structured molding tool to obtain microstructures comprising triangular based pyramids,
(c) curing the structured layer obtained by irradiation, thus obtaining a polymer film comprising a structured side and a non-structured side, and
(d) applying the polymer film obtained in step (c) with its non-structured side to the back sheet (7), or directly applying said polymer film with its non-structured side onto the encapsulant (2), step (d) optionally comprising application of an adhesion promoter and/or an adhesive, typically on the non-structured side of the polymer film as obtained in step (c).

In another embodiment, the method comprises
(a) applying a transparent radiation curable resin layer to the back sheet (7), which is preferably a glass sheet foreseen as back sheet in the preparation of the PV module, or is the module's glass back side,
(b) structuring said radiation curable resin layer by imprinting with a suitably structured molding tool to obtain microstructures comprising triangular based pyramids, and
(c) curing the structured layer obtained by irradiation.

In the above methods, the steps of structuring (b) and curing (c) may be performed subsequently or simultaneously.

In another embodiment, structuring is effected by embossing a polymer film or sheet (7) or (10).

In the solar module of the invention, the photovoltaic cells (3) are preferably silicon cells such as monocrystalline cells or multicrystalline cells, or may be cells based on any other semiconductor material used in PV cells such as organic photovoltaic materials. The cells (3) typically are bifacial cells.

Typical cells such as silicon cells may be rectangular or rounded, their longest diameter is typically from the range 5 to 20 cm, the smallest diameter is typically from the range 4 to 12 cm. Thickness of the PV cells is typically 0.1 to 1 mm, especially about 200 to 400 micrometer. PV cells are typically enclosed by a layer (2) of polymeric material such as EVA or polyvinyl alcohol; polymeric material such as EVA or polyvinyl alcohol generally also fills the gap between cells, which often ranges from 1 up to 10 mm, usually from about 2 to 5 mm. Total thickness of the solar module including protective sheet, encapsulant, PV cells, wiring and back sheet covered with the present structured layer typically is from the range 1 to 20 mm, especially 2 to 8 mm.

### Examples

### 1. Structured layer

A structured layer is prepared utilizing a carrier foil (substrate) and a UV-curable coating in combination with an imprinting process. The substrate is in this case a PET-foil primered on both sides of 175 µm total thickness (Mitsubishi Hostaphan GN 175 CT 01B). The UV-curable coating (based on an urethane acrylate, acrylate monomers, photoinitiators, and respective additives) is applied on the substrate and subsequently brought into contact with an imprinting tool bearing the negative structure of the desired final structure. The imprinting tool and the substrate are pressed against another in a way that the UV-curable coating fills the cavities of the imprinting tools negative structure. While the imprinting tool and the coated substrate are in contact, the coating is cured using UV-radiation. After curing, the imprinting tool and the coated substrate are separated, releasing the substrate with a cured, structured coating layer. During the whole imprinting process, the coating was in contact with the substrate.

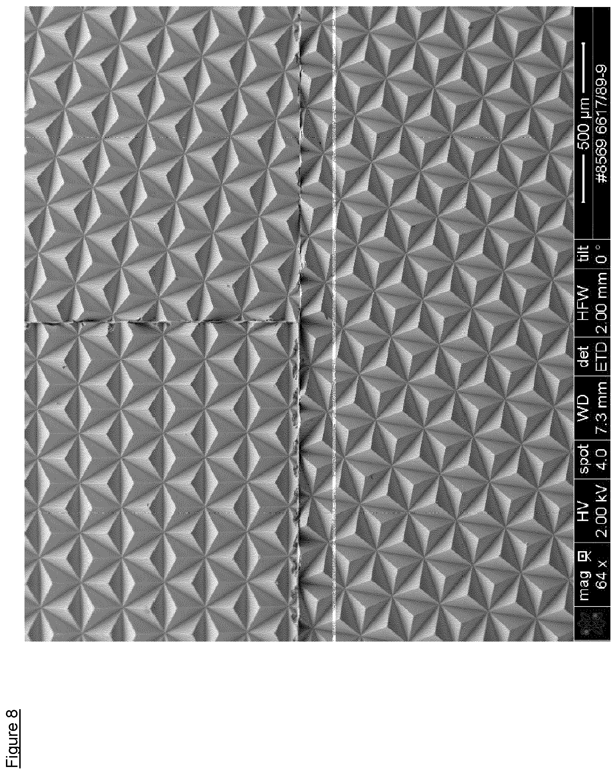

The layer obtained consisting of "cube corner" pyramids of roughly 60 micrometer height is shown in Figure 8.

Reflection measurements are made in the range from 250 to 1200 nm using a UV-Vis Spectrophotometer, weighted with the solar spectrum (AM1.5) and the Quantum efficiency of a PERC-Solar cell with samples whose back side has been blackened with paint such that no light is reflected by the back interface of the film with a front structures layer.

The structured layer described above shows a weighted average reflection of 2.2 %.

As comparison, the weighted reflection of float glass with blackened back side is determined as 4.5 %. Present structured layer thus reduces reflectivity by 2.3 % compared to float glass, thus increasing light entry e.g. by light paths IV-VI shown in Fig. 2a.

### 2. Tests with full module

Tests are performed with full sized (1.68m x 1.0m, 60 cells) bifacial glass backsheet modules, whose whole backside is coated with the structured layer of Example 1.

Efficiency measurements are performed using a flash light (solar spectrum AM1.5, 1000 W/m2) perpendicularly irradiating the module's front side or back side.
a) Front side illumination: Measurements of the output of the modules (error margin plus or minus 1 W, respectively) when irradiating the front side of the modules:
   Structured layer on the full back surface (invention): 284.5 W
   Reference module (float glass back side): 277.8 W
b) Back side illumination: Measurements of the test module's bifaciality (i.e. the output ratio (in Watt) between irradiation from the backside and from the front side) are performed using a flash light (solar spectrum AM1.5, 1000 W/m2) perpendicularly irradiating the module's back side. Because the anti-reflection effect of the present structuring shown in Example 1 works on the backside of the solar module, the expected increase in bifaciality is: 0.023 * 61% = 1.4%.

Unexpectedly, however, the bifaciality measured with the full module is 3.1 ± 0.3%, i.e. much higher than could be expected from the anti-reflection effect.

Modules of the present invention provide a distinctly higher bifaciality and efficiency than the same modules without structured back side.

### 3. Comparison to Square Structure of EP 3214659

The performance of the square structure as claimed in EP 3214659 is compared to the present "cube corner" structure as of example 1 (triangular base) using ray-tracing simulations.

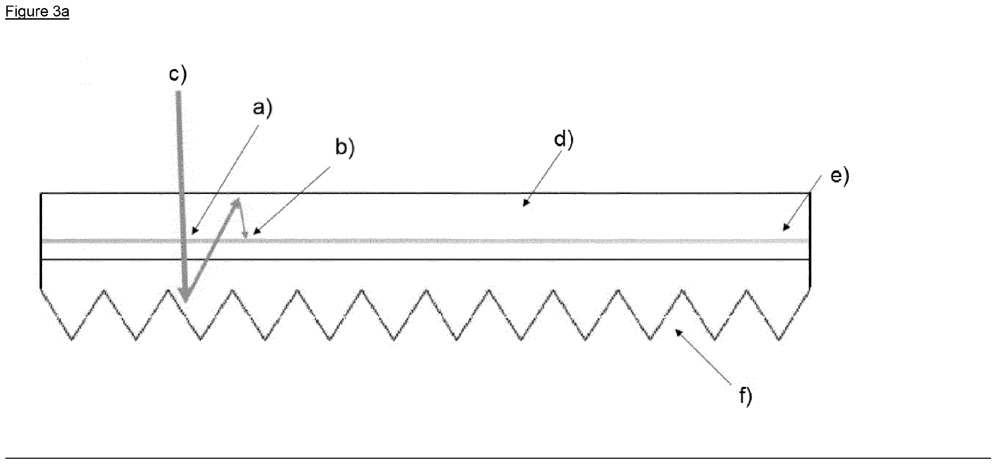

Description of the ray-tracing model: the structures are attached to the rear side of a substrate with a refractive index of n = 1.5 each (surrounding medium is air with n = 1). The substrate is tilted by 28.56° towards south, which represents an estimate for the optimum tilt angle of non-tracking PV modules in Phoenix, USA. The substrate is illuminated by direct solar radiation averaged over one year in Phoenix. A (transparent) receiver is placed inside the substrate close to the structured rear side and measures both (see Fig. 3a) of the following:
a) optical power of rays prior to their first incidence on the rear-side structure and
b) optical power of rays prior to their second incidence on the rear-side structure.

Thus, b) divided by a) gives the ratio of optical power hitting the virtual receiver a second time (and, thus, is recycled owing to the retroreflecting structure; example: for a plane rear side only 0.16% of incident power is recycled and hits the virtual receiver plane a second time, 4% reflection at rear and front side). The higher this ratio, the better the structure is working.

Parameter Space: Simulations are conducted for both structures 1) square pyramids as described in EP 3214659 (base angles 30° to 60°, giving apex angles 60° to 120°) and 2) triangle base pyramids with base angles 10° to 80°, giving apex angles of 29° to 165°. Triangle base length is 30 µm for both structures. Refractive index for both substrate and structure is 1.5 in the simulations.

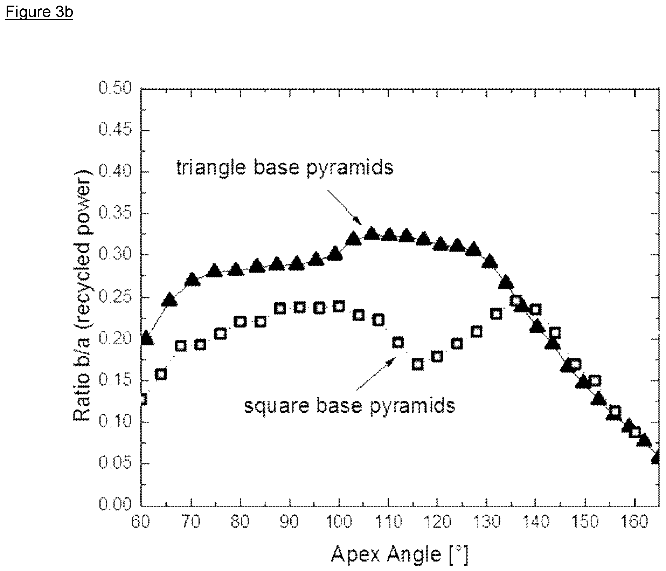

The results shown in Figure 3b demonstrate that the recycled power is significantly higher for triangle base pyramids (black triangles; present invention)
as compared to the known square base pyramids (squares),
especially in the range up to 135 deg apex angle.

Brief description of figures:
Fig. 1: Typical light paths in 2 variants of state of the art modules; light paths I to III lead to loss of light in the absence of a back reflector (8) shown on the right side of the figure, but may contribute to the PV current if reflected (left side of Fig. 1); light paths IV and V only become possible with transparent back side (absence of reflector 8, right side of Fig. 1).
Fig. 2a shows typical light paths in a PV module according to the present invention, wherein "unused" light following paths I to VI may contribute to the module's efficiency.
Fig. 2b shows a result of the present microstructured layer on the module's back side (anisotropic light flow), wherein transmission of perpendicularly incoming light from the front side and falling on the gap between cells is strongly reduced (left side of Figure 2b), while present microstructures allow nearly unhindered transmission of light perpendicularly falling on the module's back side (right side of Figure 2b).
Fig. 3a: Illustration of ray-tracing model used in example 3; the module comprises a transparent substrate (d) with embedded transparent receiver (e, standing for the PV cells 3 of the real module) and microstructured layer (f) is attached to the module's back side, substrate and microstructured layer both are of refractive index n = 1.5. The optical power of Incoming rays from solar source (c) are considered prior to their first incidence (a) on the rear-side microstructured layer and prior to their second incidence (b) on the rear-side microstructured layer.
Fig. 3b shows the comparison of present microstructured layer comprising triangular based pyramids (triangles) with a layer comprising square based pyramids (squares) as of present example 3.
Fig. 4a shows a schematic top view (left, with dimensioning) and perspective view (right) of an example for the present microstructured layer consisting of an array of triangular based pyramids (type "cube corner") whose bases have typical dimensions as indicated in the Figure ("mu" standing for micrometer); such preferred structuring of the layer (9) may be prepared by crossed gratings. The right side of Figure 4a shows the "unit cell" of the depicted structure indicating the cross section of its forming layer (9).
Fig. 4b shows an enlarged section of the structure of Fig. 4a with top view of a triangular based pyramid indicating a cut (dashed line, left side), and the resulting cross sectional view of said pyramid (right side) defining apex angle and the base angle alpha of one of the pyramid's faces, which is the angle of inclination against the back plane (i.e. the general rear surface plane defined by the lower surface of layer (2) or (7)).
Fig. 5 schematically shows an example for a transparent substrate film of thickness about 200 micrometer carrying the layer of transparent UV cured resin on one side (thickness 10 to 100 micrometer including structuring of height H on its top) and an adhesion promoter for attachment to the module's back sheet on the other side, with indication of positioning on the module's back side.
Fig. 6 shows the substrate film (10) carrying the structured layer (9) on the whole surface of the back plate (7; left side of the figure) or only attached in certain regions of the back plate in order to cover the gap between the PV cells (right side of the figure).
Fig. 7 shows the embodiment wherein the structured and UV cured resin layer (9) is applied directly on the back plate (7), which may be a polymer material or a glass sheet.
Fig. 8 shows a photomicrograph of the microstructured layer (9) as of present examples 1 and 2.

### Abbreviations

- EVA: poly(ethylene-vinyl acetate)
- PET: poly(ethylene terephthalate)
- PV: photovoltaic
- AM1.5: air mass 1.5 irradiance conditions
- HRI: high refractive index
- Jsc: short circuit current density (of PV module)
- TIR: total internal reflection
- mu: micrometer

### Numerals

- (1): Transparent front sheet (also recalled as front plate) of PV module
- (2): Encapsulant material embedding the PV cells
- (3): PV cells
- (7): Back plate
- (8): Reflecting layer (comparison)
- (9): Transparent structured layer (invention)
- (10): Optional carrier film for structured layer (9)

## Claims

1. Photovoltaic module comprising one or more bifacial photovoltaic cells (3), which module comprises a front side exposing an upper external surface designed for receiving direct sunlight and a rear side exposing a lower external surface designed for receiving diffuse light, wherein the lower external surface is formed, at least in part, by a microstructured layer (9),
**characterized in that** said microstructured layer (9) comprises pyramidal microstructures whose triangular bases are fixed in said layer (9).

2. Photovoltaic module according to claim 1, comprising a front plate (1)
optionally covered by an antireflex layer, the front plate (1) covering the photovoltaic cells (3), which cells are embedded in an encapsulant (2), and an optional back sheet (7) and/or interlayer (10),
wherein front plate (1), encapsulant (2), photovoltaic cells (3), and optional antireflex layer, back sheet (7) and interlayer (10), stand in optical contact with each other;
and front plate (1), encapsulant (2), and optional antireflex layer and back sheet (7) and interlayer (10), each are made of a transparent material,
wherein the encapsulant (2) or back sheet (7) or interlayer (10) thus forms an essentially plane rear surface, which is, at least in part, covered by the microstructured layer (9) comprising a plurality of triangular based pyramids.

3. Photovoltaic module of claim 1 or 2, wherein the microstructured layer (9) comprises pyramidal microstructures with triangular bases and apexes pointing away from the module's front side.

4. Photovoltaic module of claim 2 or 3, wherein the microstructured layer (9) comprises pyramids, whose lateral faces are inclined against the back plane defined by the essentially plane rear surface by an angle from the range 15 to 89°, preferably 15 to 75°, especially 25 to 70°.

5. Photovoltaic module according to any of the preceding claims, wherein the pyramidal microstructures fill at least 90%, especially at least 95%, of the surface of the microstructured layer (9).

6. Photovoltaic module according to any of the preceding claims, wherein the length of the pyramid's triangular bases are from the range 1 to 600 micrometer, and the pyramid's apex angle is from the range 30° to 135°, especially 60 to 120°.

7. Photovoltaic module according to any of the preceding claims comprising a plurality of PV cells separated by gaps typically of 1 to 10 mm width, wherein the microstructured layer (9) is arranged at least below these gaps.

8. Photovoltaic module according to any of the preceding claims, wherein the microstructured layer (9) covers a polymer film (10), which stands in optical contact with the module's back sheet (7), or the microstructured layer (9) covers a polymer film (10), which stands in optical contact with the encapsulant (2).

9. Photovoltaic module according to any of the claims 1 to 8, wherein the microstructured layer (9) directly covers the module's back sheet (7), which back sheet (7) is a polymer sheet or glass sheet.

10. Photovoltaic module according claim 8, wherein the microstructured layer (9) of transparent material comprises a resin cured by actinic radiation or an embossed polymer material, especially a resin cured by UV radiation.

11. Method for the manufacturing of a photovoltaic module comprising PV cells capable of converting light incoming from the front side and from the rear side, which method comprises the step of structuring the module's transparent back side with microstructures in a layer of a transparent coating material either by applying, structuring and curing said coating material on the module's back side, or by applying a transparent sheet onto the module's back side wherein said sheet contains one microstructured surface comprising an UV cured coating material, **characterized in that** said microstructures comprise a plurality of triangular based pyramides.

12. Method of claim 11, wherein the step of structuring the module's transparent back side comprises
(a) applying a transparent radiation curable resin layer to a polymer film such as a PET film,
(b) structuring said radiation curable resin layer by imprinting with a suitably structured molding tool to obtain microstructures comprising triangular based pyramids,
(c) curing the structured layer obtained by irradiation, thus obtaining a polymer film comprising a structured and a non-structured side, and
(d) applying the polymer film obtained in step (c) with its non-structured side to the back sheet (7), or directly applying said polymer film with its non-structured side onto the encapsulant (2), step (d) optionally comprising application of an adhesion promoter and/or an adhesive.

13. Method of claim 11, wherein the step of structuring the module's transparent back side comprises
(a) applying a transparent radiation curable resin layer to the back sheet (7) such as a glass sheet,
(b) structuring said radiation curable resin layer by imprinting with a suitably structured molding tool to obtain microstructures comprising triangular based pyramids, and
(c) curing the structured layer obtained by irradiation.

14. Method according to any of claims 11-13, wherein the length of the pyramid's triangular bases are from the range 1 to 600 micrometer, and the pyramid's apex angle is from the range 30° to 135°, especially 60 to 120°.

15. Use of a transparent polymer film comprising a microstructured surface, which surface comprises a plurality of triangular based pyramids, for the manufacture of a photovoltaic module comprising PV cells capable of converting light incoming from the front side and from the rear side, especially as back sheet of the photovoltaic module.

## Patentansprüche

1. Photovoltaikmodul umfassend eine oder mehrere bifaziale Photovoltaikzellen (3), wobei das Modul eine Vorderseite mit einer freiliegenden oberen Außenfläche, die zum Empfangen von direktem Sonnenlicht ausgelegt ist, und eine Rückseite mit einer freiliegenden unteren Außenfläche, die zum Empfangen von diffusem Licht ausgelegt ist, umfasst, wobei die untere Außenfläche wenigstens zum Teil durch eine mikrostrukturierte Schicht (9) gebildet ist,
**dadurch gekennzeichnet, dass** die mikrostrukturierte Schicht (9) pyramidenförmige Mikrostrukturen umfasst, deren dreieckige Grundflächen in der Schicht (9) fixiert sind.

2. Photovoltaikmodul nach Anspruch 1, umfassend eine Frontplatte (1), die gegebenenfalls mit einer Antireflexschicht bedeckt ist, wobei die Frontplatte (1) die Photovoltaikzellen (3) bedeckt, wobei die Zellen in einem Verkapselungsstoff (2) eingebettet sind, und eine optionale Rückschicht (7) und/oder Zwischenschicht (10), wobei Frontplatte (1), Verkapselungsstoff (2), Photovoltaikzellen (3) und optionale Antireflexschicht,
Rückschicht (7) und Zwischenschicht (10) in optischem Kontakt miteinander stehen;
und Frontplatte (1), Verkapselungsstoff (2) und optionale Antireflexschicht und Rückschicht (7) und Zwischenschicht (10) jeweils aus einem transparenten Material bestehen,
wobei der Verkapselungsstoff (2) oder die Rückschicht (7) oder Zwischenschicht (10) eine im Wesentlichen ebene hintere Oberfläche bildet, die wenigstens zum Teil mit der mikrostrukturierten Schicht (9), die eine Vielzahl von Pyramiden mit dreieckiger Grundfläche umfasst, bedeckt ist.

3. Photovoltaikmodul nach Anspruch 1 oder 2, wobei die mikrostrukturierte Schicht (9) pyramidenförmige Mikrostrukturen mit dreieckigen Grundflächen und Scheiteln, die von der Vorderseite des Moduls weg zeigen, umfasst.

4. Photovoltaikmodul nach Anspruch 2 oder 3, wobei die mikrostrukturierte Schicht (9) Pyramiden umfasst, deren Seitenflächen gegen die von der im Wesentlichen ebenen hinteren Oberfläche definierte rückseitige Ebene um einen Winkel in dem Bereich von 15 bis 89°, vorzugsweise 15 bis 75°, insbesondere 25 bis 70°, geneigt sind.

5. Photovoltaikmodul nach einem der vorstehenden Ansprüche, wobei die pyramidenförmigen Mikrostrukturen wenigstens 90 %, insbesondere wenigstens 95 %, der Oberfläche der mikrostrukturierten Schicht (9) füllen.

6. Photovoltaikmodul nach einem der vorstehenden Ansprüche, wobei die Länge der dreieckigen Grundflächen der Pyramiden in dem Bereich von 1 bis 600 Mikrometer liegt und der Scheitelwinkel der Pyramide in dem Bereich von 30° bis 135°, insbesondere von 60 bis 120°, liegt.

7. Photovoltaikmodul nach einem der vorstehenden Ansprüche, das eine Vielzahl von PV-Zellen umfasst, die durch Spalte von typischerweise 1 bis 10 mm Breite getrennt sind, wobei die mikrostrukturierte Schicht (9) wenigstens unterhalb dieser Spalte angeordnet ist.

8. Photovoltaikmodul nach einem der vorstehenden Ansprüche, wobei die mikrostrukturierte Schicht (9) einen Polymerfilm (10) bedeckt, der in optischem Kontakt mit der Rückschicht (7) des Moduls steht, oder die mikrostrukturierte Schicht (9) einen Polymerfilm (10) bedeckt, der in optischem Kontakt mit dem Verkapselungsstoff (2) steht.

9. Photovoltaikmodul nach einem der Ansprüche 1 bis 8, wobei die mikrostrukturierte Schicht (9) die Rückschicht (7) des Moduls direkt bedeckt, wobei die Rückschicht (7) eine Polymerschicht oder Glasschicht ist.

10. Photovoltaikmodul nach Anspruch 8, wobei die mikrostrukturierte Schicht (9) aus transparentem Material ein durch aktinische Strahlung gehärtetes Harz oder ein geprägtes Polymermaterial, insbesondere ein durch UV-Strahlung gehärtetes Harz, umfasst.

11. Verfahren zur Herstellung eines Photovoltaikmoduls umfassend PV-Zellen, die von der Vorderseite und von der Rückseite einfallendes Licht umwandeln können, wobei das Verfahren den Schritt des Strukturierens der transparenten Rückseite des Moduls mit Mikrostrukturen in einer Schicht eines transparenten Beschichtungsmaterials entweder durch Aufbringen, Strukturieren und Aushärten des Beschichtungsmaterials auf der Rückseite des Moduls oder durch Aufbringen einer transparenten Folie auf die Rückseite des Moduls umfasst, wobei die Folie eine mikrostrukturierte Oberfläche aufweist, die ein UV-gehärtetes Beschichtungsmaterial umfasst, **dadurch gekennzeichnet, dass** die Mikrostrukturen eine Vielzahl von Pyramiden mit dreieckiger Grundfläche umfassen.

12. Verfahren nach Anspruch 11, wobei der Schritt des Strukturierens der transparenten Rückseite des Moduls umfasst
(a) Aufbringen einer transparenten strahlungshärtbaren Harzschicht auf einen Polymerfilm, wie z.B. einen PET-Film,
(b) Strukturieren der strahlungshärtbaren Harzschicht durch Prägen mit einem geeignet strukturierten Formwerkzeug, um Mikrostrukturen zu erhalten, die Pyramiden mit dreieckiger Grundfläche umfassen,
(c) Härten der erhaltenen strukturierten Schicht durch Bestrahlung, um einen Polymerfilm zu erhalten, der eine strukturierte und eine nicht strukturierte Seite umfasst, und
(d) Aufbringen des bei Schritt (c) erhaltenen Polymerfilms mit seiner nicht strukturierten Seite auf die Rückschicht (7) oder direktes Aufbringen des Polymerfilms mit seiner nicht strukturierten Seite auf den Verkapselungsstoff (2), wobei Schritt (d) gegebenenfalls Aufbringen eines Haftvermittlers und/oder eines Klebstoffs umfasst.

13. Verfahren nach Anspruch 11, wobei der Schritt des Strukturierens der transparenten Rückseite des Moduls umfasst
(a) Aufbringen einer transparenten strahlungshärtbaren Harzschicht auf die Rückschicht (7), wie z.B. eine Glasplatte,
(b) Strukturieren der strahlungshärtbaren Harzschicht durch Prägen mit einem geeignet strukturierten Formwerkzeug, um Mikrostrukturen zu erhalten, die Pyramiden mit dreieckiger Grundfläche umfassen, und
(c) Härten der erhaltenen strukturierten Schicht durch Bestrahlung.

14. Verfahren nach einem der Ansprüche 11-13, wobei die Länge der dreieckigen Grundflächen der Pyramiden in dem Bereich von 1 bis 600 Mikrometer liegt und der Scheitelwinkel der Pyramiden in dem Bereich von 30° bis 135°, insbesondere von 60 bis 120°, liegt.

15. Verwendung einer transparenten Polymerfolie, die eine mikrostrukturierte Oberfläche umfasst, wobei die Oberfläche eine Vielzahl von Pyramiden mit dreieckiger Grundfläche umfasst, für die Herstellung eines Photovoltaikmoduls mit PV-Zellen, die von der Vorderseite und von der Rückseite einfallendes Licht umwandeln können, insbesondere als Rückschicht des Photovoltaikmoduls.

## Revendications

1. Module photovoltaïque comprenant une ou plusieurs cellules photovoltaïques bifaciales (3), lequel module comprend une face avant exposant une surface externe supérieure conçue pour recevoir la lumière directe du soleil et une face arrière exposant une surface externe inférieure conçue pour recevoir de la lumière diffuse, la surface externe inférieure étant formée, au moins en partie, par une couche microstructurée (9),
**caractérisé en ce que** ladite couche microstructurée (9) comprend des microstructures pyramidales dont les bases triangulaires sont fixées dans ladite couche (9).

2. Module photovoltaïque selon la revendication 1, comprenant une plaque avant (1) éventuellement recouverte d'une couche antireflet, la plaque avant (1) recouvrant les cellules photovoltaïques (3), lesquelles cellules sont noyées dans un encapsulant (2), et une feuille arrière (7) et/ou une couche intercalaire (10) facultatives,
dans lequel la plaque avant (1), l'encapsulant (2), les cellules photovoltaïques (3), et la couche antireflet, la feuille arrière (7) et la couche intercalaire (10) facultatives sont en contact optique les uns avec les autres ;
et la plaque avant (1), l'encapsulant (2), et la couche antireflet, la feuille arrière (7) et la couche intercalaire (10) facultatives sont chacun constitués d'un matériau transparent,
l'encapsulant (2), ou la feuille arrière (7), ou la couche intercalaire (10) formant ainsi une surface arrière essentiellement plane qui est, au moins en partie, recouverte par la couche microstructurée (9) comprenant une pluralité de pyramides à base triangulaire.

3. Module photovoltaïque de la revendication 1 ou 2, dans lequel la couche microstructurée (9) comprend des microstructures pyramidales avec des bases triangulaires et des sommets pointant à l'opposé de la face avant du module.

4. Module photovoltaïque de la revendication 2 ou 3, dans lequel la couche microstructurée (9) comprend des pyramides dont les faces latérales sont inclinées par rapport au plan arrière défini par la surface arrière essentiellement plane d'un angle compris entre 15 et 89°, de préférence entre 15 et 75°, en particulier entre 25 et 70°.

5. Module photovoltaïque selon l'une quelconque des revendications précédentes, dans lequel les microstructures pyramidales remplissent au moins 90 %, en particulier au moins 95 %, de la surface de la couche microstructurée (9).

6. Module photovoltaïque selon l'une quelconque des revendications précédentes, dans lequel la longueur des bases triangulaires des pyramides est comprise entre 1 et 600 micromètres, et l'angle au sommet des pyramides est compris entre 30° et 135°, en particulier entre 60 et 120°.

7. Module photovoltaïque selon l'une quelconque des revendications précédentes, comprenant une pluralité de cellules PV séparées par des espaces d'une largeur généralement de 1 à 10 mm, la couche microstructurée (9) étant disposée au moins sous ces espaces.

8. Module photovoltaïque selon l'une quelconque des revendications précédentes, la couche microstructurée (9) recouvrant un film polymère (10) qui est en contact optique avec la feuille arrière (7) du module, ou la couche microstructurée (9) recouvrant un film polymère (10) qui est en contact optique avec l'encapsulant (2).

9. Module photovoltaïque selon l'une quelconque des revendications 1 à 8, la couche microstructurée (9) recouvrant directement la feuille arrière (7) du module, laquelle feuille arrière (7) est une feuille de polymère ou une feuille de verre.

10. Module photovoltaïque selon la revendication 8, dans lequel la couche microstructurée (9) en matériau transparent comprend une résine durcie par un rayonnement actinique ou un matériau polymère gaufré, en particulier une résine durcie par un rayonnement UV.

11. Procédé de fabrication d'un module photovoltaïque comprenant des cellules PV pouvant convertir la lumière arrivant de la face avant et de la face arrière, lequel procédé comprend l'étape de structuration de la face arrière transparente du module avec des microstructures dans une couche d'un matériau de revêtement transparent soit par application, structuration et durcissement dudit matériau de revêtement sur la face arrière du module, soit par application d'une feuille transparente sur la face arrière du module, ladite feuille contenant une surface microstructurée comprenant un matériau de revêtement durci aux UV, **caractérisé en ce que** lesdites microstructures comprennent une pluralité de pyramides à base triangulaire.

12. Procédé de la revendication 11, dans lequel l'étape de structuration de la face arrière transparente du module comprend
(a) l'application d'une couche de résine transparente durcissable par rayonnement à un film polymère tel qu'un film de PET,
(b) la structuration de ladite couche de résine durcissable par rayonnement par estampage avec un outil de moulage adéquatement structuré pour obtenir des microstructures comprenant des pyramides à base triangulaire,
(c) le durcissement de la couche structurée obtenue par irradiation, ce qui permet d'obtenir un film polymère comprenant une face structurée et une face non structurée, et
(d) l'application du film polymère obtenu à l'étape (c) avec sa face non structurée sur la feuille arrière (7), ou l'application directe dudit film polymère avec sa face non structurée sur l'encapsulant (2), l'étape (d) comprenant éventuellement l'application d'un promoteur d'adhérence et/ou d'un adhésif.

13. Procédé de la revendication 11, dans lequel l'étape de structuration de la face arrière transparente du module comprend
(a) l'application d'une couche de résine transparente durcissable par rayonnement sur la feuille arrière (7) telle qu'une feuille de verre,
(b) la structuration de ladite couche de résine durcissable par rayonnement par estampage avec un outil de moulage adéquatement structuré pour obtenir des microstructures comprenant des pyramides à base triangulaire, et
(c) le durcissement de la couche structurée obtenue par irradiation.

14. Procédé selon l'une quelconque des revendications 11 à 13, dans lequel la longueur des bases triangulaires des pyramides est comprise entre 1 et 600 micromètres, et l'angle au sommet des pyramides est compris entre 30° et 135°, en particulier entre 60 et 120°.

15. Utilisation d'un film polymère transparent comprenant une surface microstructurée, laquelle surface comprend une pluralité de pyramides à base triangulaire, pour la fabrication d'un module photovoltaïque comprenant des cellules PV pouvant convertir la lumière arrivant de la face avant et de la face arrière, en particulier comme feuille arrière du module photovoltaïque.
